# EUROPÄISCHE PATENTSCHRIFT

(11) **EP 2 464 938 B1**
(45) Veröffentlichungstag und Bekanntmachung des Hinweises auf die Patenterteilung: **31.07.2013**
(21) Anmeldenummer: 10749600.2
(22) Anmeldetag: 12.08.2010
(51) Int. Cl.: F27B 9/30, C03B 27/044, C03B 29/08

(54) **VORRICHTUNG UND BEHANDLUNGSKAMMER ZUR THERMISCHEN BEHANDLUNG VON SUBSTRATEN**
DEVICE AND TREATMENT CHAMBER FOR THERMALLY TREATING SUBSTRATES
DISPOSITIF ET CHAMBRE DE TRAITEMENT POUR LE TRAITEMENT THERMIQUE DE SUBSTRATS

(30) Priorität: 14.08.2009 DE 102009037299
(43) Veröffentlichungstag der Anmeldung: 20.06.2012
(73) Patentinhaber: Leybold Optics GmbH, 63755 Alzenau (DE)
(72) Erfinder: NOVAK, Emmerich, 14797 Kloster Lehnin (DE); TRUBE, Jutta, 63776 Mömbris (DE)
(74) Vertreter: Pohlmann, Bernd Michael
(86) Internationale Anmeldenummer: PCT/EP2010/004947
(87) Internationale Veröffentlichungsnummer: WO 2011/018226

(56) Entgegenhaltungen:
- EP-A1- 0 265 787
- EP-A1- 1 491 509
- WO-A1-00/37371
- WO-A1-03/006390
- DE-A1- 1 471 831
- DE-T2- 69 812 251

## Beschreibung

Die Erfindung betrifft eine Behandlungskammer zur thermischen Bearbeitung eines Substrats nach dem Oberbegriff des Anspruchs 1, wie sie beispielsweise in der gattungsbildenden DE 698 12 251 T2 beschrieben ist. Die Behandlungskammer kann als Wärmebehandlungskammer (Heizkammer) oder als Kühlkammer ausgestaltet sein. Die Erfindung betrifft weiterhin eine Vorrichtung mit einer Wärmebehandlungs- und einer Kühlkammer zur thermischen Bearbeitung eines Substrats sowie ein Verfahren zur thermischen Bearbeitung eines Substrats.

Bei der Oberflächenbehandlung von Substraten, z.B. beim Aufbringen von transparenten leitfähigen Oxidschichten (TCO) im Zuge der Herstellung von Flachdisplays und Solarzellen oder beim Beschichten von Substraten unter Verwendung der CIGS-Dünnschichttechnologie sind oftmals Prozessschritte notwendig, in denen das Substrat (gemeinsam mit den ggf. auf dem Substrat aufgebrachten Beschichtungen) einer thermischen Vor- und/oder Nachbehandlung unterzogen wird. Hierzu wird das Substrat typischerweise mit Hilfe einer Wärmequelle auf die gewünschten Temperatur erwärmt, für eine vorgegebene Zeit auf dieser Temperatur gehalten und anschließend abgekühlt. Dabei ist es aus prozessökonomischen und/oder technischen Gründen in der Regel von Vorteil, eine möglichst schnelle Erwärmung bzw. Abkühlung des Substrats zu erreichen. Gleichzeitig muss jedoch gewährleistet sein, dass beim Erhitzen und Abkühlen die Temperaturgradienten im Inneren des Substrats möglichst gering sind, weil ansonsten vorübergehende oder permanente Verformungen des Substrats auftreten, die zu einer Schädigung der Beschichtung (Risse, innere Spannungen etc.) und/oder des Substrats (Verbiegungen, Blasenbildung, bistabile Zustände des Substratmaterials etc.) führen können. Diese Problematik besteht verschärft bei Substraten aus Werkstoffen mit geringer thermischer Leitfähigkeit, z.B. Glaswerkstoffen, weil Temperaturunterschiede innerhalb des Substrats bei diesen Werkstoffen nur langsam ausgeglichen werden können.

Um diesem Problem zu begegnen, wird in der DE 698 12 251 T2 vorgeschlagen, zum Erhitzen des Substrats ein halbkonvektives, erzwungenes Luftsystem zu verwenden. Dabei erfolgt die Erhitzung des Substrats einerseits durch Bestrahlung mit Hilfe elektrischer Widerstandsheizelemente und andererseits durch Luftverteiler, die die erhitzte Luft in Richtung des Substrats leiten. Die Konvektionshitze, die von den Luftverteilern geliefert wird, unterstützt somit die Strahlungswärme, die von den elektrischen Widerstandselementen geliefert wird. Weiterhin kann durch eine gezielte (lokale) Konvektionserhitzung einem durch die Strahlungserhitzung erzeugten Temperaturgradienten entgegengewirkt werden. Auf diese Weise soll eine Erhitzung mit einem gleichmäßigeren Temperaturprofil über das Substrat hinweg erreicht werden. Die Luftverteiler werden dabei von einer Umwälzpumpe (Vertilator) gespeist, die innerhalb oder außerhalb der Wärmebehandlungskammer angeordnet ist.

Ausgehend von der aus der DE 698 12 251 T2 bekannten Heizeinrichtung liegt der Erfindung die Aufgabe zugrunde, eine Wärmebehandlungskammer und/oder eine Kühlkammer sowie ein Verfahren zur thermischen Bearbeitung von Substraten bereitzustellen, die es ermöglichen, die lokale Erhitzung bzw. Abkühlung des Substrats besonders gut zu kontrollieren und auf besonders effiziente und kostengünstige Weise eine schnelle Erhitzung bzw. Kühlung eines Substrats zu erreichen, ohne dass es zu Schädigungen des Substrats oder der Beschichtungen aufgrund von thermischen Gradienten kommt. Weiterhin soll eine Vorrichtung mit einer Wärmebehandlungskammer und einer Kühlkammer zur thermischen Bearbeitung von Substraten bereitgestellt werden.

Die Aufgabe wird durch die Merkmale der unabhängigen Ansprüche gelöst. Vorteilhafte Ausgestaltungen sind Gegenstand der Unteransprüche.

Danach erfolgt die Erwärmung bzw. Kühlung des Substrats durch Konvektion eines temperierten Gases, das durch eine Gasführungseinrichtung auf das Substrat geleitet wird. Die Behandlungskammer, in der das Substrat während der thermischen Behandlung aufgenommen ist, umfasst eine Abführeinrichtung zur gezielten Abfuhr des Gases, durch das die konvektive Erwärmung bzw. Abkühlung des Substrats erreicht wird. Diese Abführeinrichtung ermöglicht eine definierte Rückführung, insbesondere eine Wiederverwendung des für die Heizung bzw. Kühlung verwendeten Gases.

In einer vorteilhaften Ausgestaltung der Erfindung ist die Behandlungskammer ein geschlossener Raum. Das Substrat wird durch eine Schleuse in die Behandlungskammer eingeführt und dort mit Hilfe einer Transporteinrichtung befördert und gelagert. In einer solchen gasdicht verschließbaren thermischen Behandlungskammer erfolgt die Zu- und Abfuhr des für die Heizung bzw. Kühlung verwendeten Gases vorteilhafterweise in einem geschlossenen Gaskreislauf, der die Gasführungseinrichtung, den Innenraum der Behandlungskammer und die Abführeinrichtung umfasst. Dies ist insbesondere dann von Vorteil, wenn die thermische Behandlung mit Hilfe von Gasen erfolgt, die reaktiv oder toxisch sind und daher nicht in die Umgebung entweichen sollen. Weiterhin geht der Anteil an Heiz- oder Kühlleistung, den das Gas nicht an das Substrat übertragen konnte, nicht verloren, sondern fließt über die Abführeinrichtung durch den geschlossenen Kreislauf wieder der Gasführungseinrichtung zu. Auf diese Weise kann Heiz- bzw. Kühlenergie gespart werden.

Vorteilhafterweise ist die Abführeinrichtung in einer solchen Weise gestaltet, dass sie eine lokal definierte Abfuhr des auf das Substrat geleiteten Gases gestattet, so dass das aus einer Auslassöffnung der Gasführungseinrichtung austretende Gas in unmittelbarer Umgebung dieser Auslassöffnungen abgesaugt wird. Einzelnen Auslassöffnungen (oder Gruppen von Auslassöffnungen) können Abführhauben zugeordnet sein, die so geformt sind, dass sie das aus diesen Auslassöffnungen entströmende temperierte Gas gezielt abführen. Das Heiz- bzw. Kühlgas trifft also nur in einem lokal begrenzten Bereich auf das Substrat und wird lokal abgesaugt, bevor es sich ausbreiten kann. Auf diese Weise kann sehr differenziert und kontrolliert eine lokale Erwärmung bzw. Abkühlung des Substrats durchgeführt werden, und thermische Gradienten im Substrat können vermieden (oder gezielt erzeugt) werden. Durch das Absaugen des Gases direkt im Bereich der Auslassöffnungen kann weiterhin verhindert werden, dass das Gas in Kontakt mit den Wänden der Behandlungskammer kommt. Dies ist insbesondere dann von großem Vorteil, wenn zur konvektiven Heizung bzw. Kühlung ein technisches Gas (z.B. ein korrosives oder toxisches Gas) zum Einsatz kommt, das Verschmutzungen oder Schäden an den Kammerwänden hervorrufen kann. Die Abführeinrichtungen wirken somit als Abschirmvorrichtungen, die die Kammerwände vor dem Einfluss des Gases schützen.

Vorteilhafterweise sind die Auslassöffnungen der Gasführungseinrichtung als Düsen gestaltet, mit deren Hilfe der Gasstrom gezielt (beispielsweise definiert fokussiert oder defokussiert) auf einen der Düse gegenüberliegenden Bereich der Substratoberfläche geleitet werden kann. Die Düsen und/oder die den Düsen zugeordneten Rohrabschnitte der Gasführungseinrichtung können mit steuerbaren Ventilen versehen sein. Dann können mit Hilfe einer Steuerungseinrichtung die Ventile in den Düsen einzeln oder gruppenweise angesteuert werden, um die Alienge und/oder Geschwindigkeit des durch die Düse ausströmenden Gases zu kontrollieren.

Zur Temperierung des Gases, das zur Konvektionsheizung bzw. -kühlung des Substrats verwendet wird, enthält die Gasführungseinrichtung zweckmäßigerweise einen Wärmetauscher, mit dessen Hilfe das Gas auf die gewünschte Temperatur gebracht wird. Soll das Gas aufgeheizt werden, so kann die Gasführungseinrichtung alternativ oder zusätzlich zum Wärmetauscher eine elektrisch betreibbare Heizvorrichtung enthalten. Weiterhin enthält die Gasführungseinrichtung eine Pumpe, mit deren Hilfe das Gas auf das Substrat gefördert wird. Ist die Gasführungseinrichtung Teil eines geschlossenen Gaskreislaufs, so dient die Pumpe gleichzeitig zum Absaugen des aus den Auslassöffnungen ausgetretenen Gases über die Abführeinrichtung. Die Pumpe kann gesteuert oder geregelt betrieben werden. Weiterhin kann die Gasführungseinrichtung eine Trocknungsvorrichtung und/oder eine Filtervorrichtung zur Reinigung des auf die Substratoberfläche zugeleiteten Gases enthalten; dies ist insbesondere dann zweckmäßig, wenn die Konvektionsheizung bzw. -kühlung in einem geschlossenen Gaskreislauf erfolgt, da das zirkulierende Gas auf diese Weise regelmäßig getrocknet und/oder gereinigt werden kann.

Wird die Behandlungskammer zum Erhitzen von Substraten verwendet, so können in der Behandlungskammer - neben der Gasführungseinrichtung zum konvektiven Erhitzen des Substrats - zusätzlich Heizmittel, insbesondere elektrische Widerstandsheizelemente, vorgesehen sein, die dem Substrat Strahlungswärme zuführen. Die Wände der Behandlungskammer können aus einem wärmereflektierenden Werkstoff bestehen, um die von dem Heizmittel abgestrahlte Leistung in Richtung des Substrates zu leiten.

Um die Behandlungskammer, die deren Innenraum im Betrieb erhitzt oder gekühlt werden soll, thermisch gegenüber der Umgebung abzuschirmen, kann die Behandlungskammer mit einem Thermoisolationsschild versehen sein. Auf diese Weise kann eine schnellere Heizung bzw. Kühlung des Kammerinnenraums, insbesondere des Substrats, erreicht werden, und die zur Aufrechterhaltung einer gewünschten Temperatur erforderliche Heiz- bzw. Kühlleistung kann reduziert werden. Das Thermoisolationsschild kann beispielsweise als eine gasdicht verschließbare Außenkammer, insbesondere eine Vakuumkammer, ausgestaltet sein, die die Innenkammer, in der die thermische Bearbeitung des Substrats stattfindet, allseitig umschließt. Der zwischen Innen- und Außenkammer gelegene Hohlraum isoliert die (erhitzte oder gekühlte) Innenkammer gegenüber der Umgebung.

Alternativ kann der Thermoisolationsschild durch eine - vorzugsweise in der Wand der Behandlungskammer angeordnete - Temperierungseinrichtung gebildet sein, die die Kammerwand aktiv kühlt bzw. heizt. Insbesondere kann die Behandlungskammer mit einem in die Kammerwand integrierten Kanalsystem versehen sein, in der ein flüssiges Heiz- oder Kühlmedium, beispielsweise ein Öl, zirkuliert. Ist die Behandlungskammer eine Heizkammer, die bei hohen Temperaturen betrieben wird, so können die Kammerwände gezielt gekühlt werden, um die thermische Belastung der Umgebung - insbesondere einer die Heizkammer umgebenden Vakuumkammer - zu minimieren.

Im Folgenden wird die Erfindung anhand eines in den Figuren dargestellten Ausführungsbeispiels näher erläutert. Dabei zeigen:
- Fig. 1: eine schematische Schnittdarstellung einer Vorrichtung zum thermischen Bearbeiten von Substraten, mit einer Wärmebehandlungskammer und einer Kühlkammer;
- Fig. 2a: eine schematische Schnittdarstellung der Wärmebehandlungskammer der Fig. 1 mit einem geschlossenen Gasführungskreislauf;
- Fig. 2b: eine Schnittdarstellung der Wärmebehandlungskammer der Figur 2a gemäß der Schnittlinie IIb-IIb in Figur 2a.

In den Zeichnungen sind einander entsprechende Elemente mit denselben Bezugszeichen bezeichnet. Die Zeichnungen stellen ein schematisches Ausführungsbeispiel dar und geben keine spezifischen Parameter der Erfindung wieder Weiterhin dienen die Zeichnungen lediglich zur Erläuterung einer vorteilhaften Ausführungsform der Erfindung und sollen nicht in einer solchen Weise interpretiert werden, dass sie den Schutzbereich der Erfindung einengen.

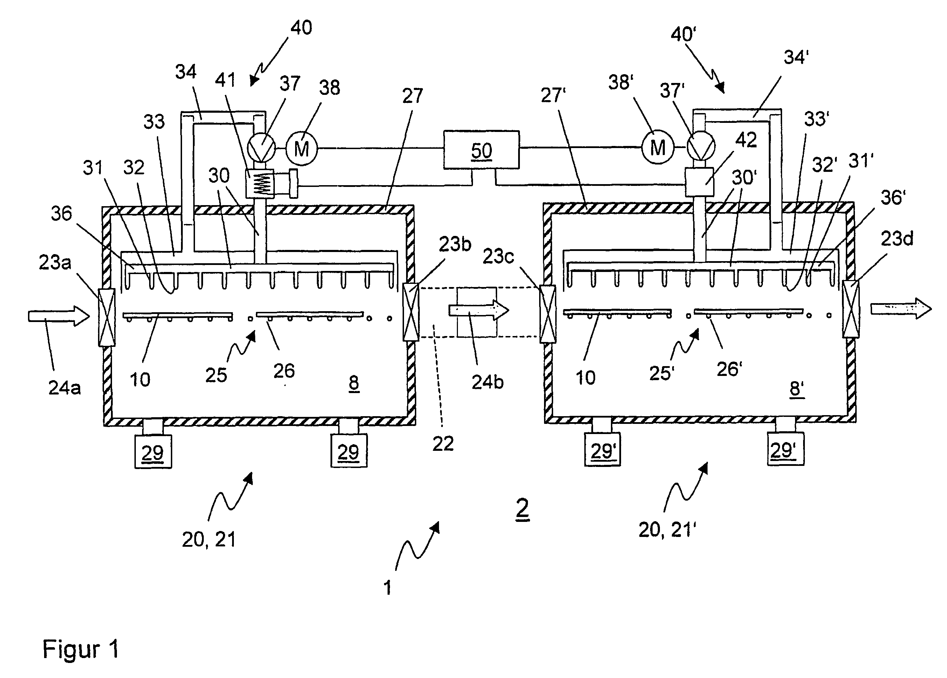

Figur 1 zeigt eine schematische Schnittdarstellung einer Vorrichtung 1 zur thermischen Bearbeitung von Substraten 10. Unter dem Begriff "substrat" soll hierbei ein beliebiger zu bearbeitender, zu beschichtender und/oder bereits beschichteter Gegenstand verstanden werden, also sowohl ein (evtl. vorbehandeltes) Trägermaterial als solches an als auch ein Trägermaterial mit Einfach- oder Mehrfachbeschichtungen. In dem in den Figuren gezeigten Ausführungsbeispiel ist das Substrat ein flächenhaftes Werkstück aus Glas, dessen Fläche zwischen einigen Quadratzentimetern und einigen Quadratmetern liegen kann. Unter "thermischer Bearbeitung" soll jeder Prozess bzw. Prozessschritt verstanden werden, der mit einer Erwärmung und/oder eine Kühlung des Substrats einhergeht.

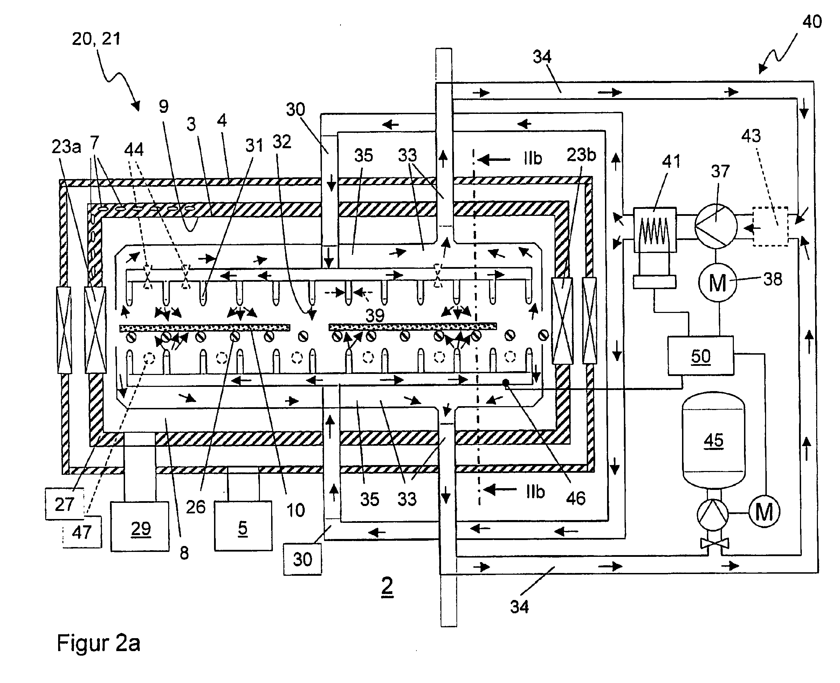

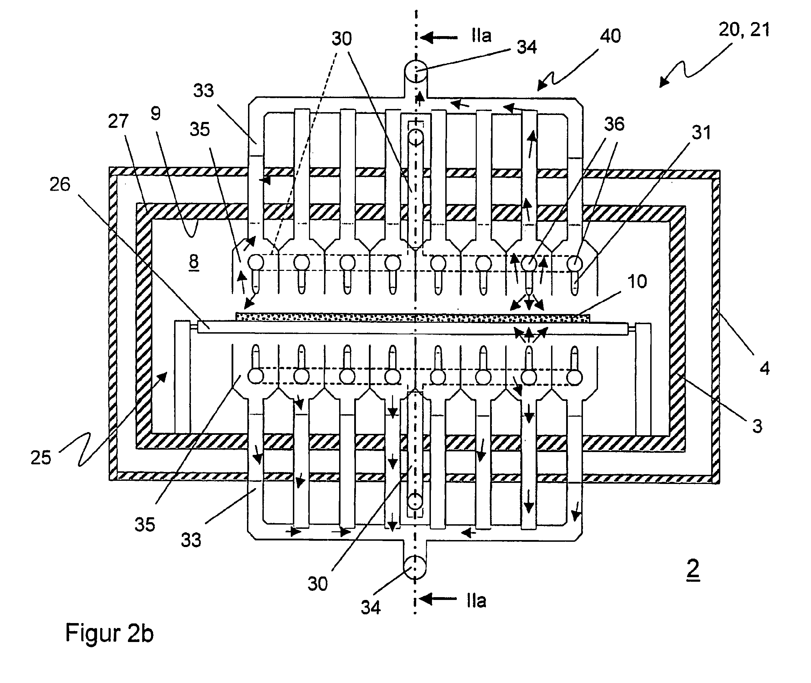

Die Vorrichtung 1 umfasst zwei thermische Behandlungskammern 20, nämlich eine Wärmebehandlungskammer 21 und eine Kühlkammer 21'. Schnittdarstellungen der Wärmebehandlungskammer 21 sind im Detail in Figuren 2a und 2b gezeigt. Das zu behandelnde Substrat 10 wird über eine Schleuse 23a in die Wärmebehandlungskammer 21 eingeführt (Pfeil 24a), wo das Substrat 10 mit Hilfe eines erhitzten Gases, das über eine Gasführungseinrichtung 30 in die Wärmebehandlungskammer 21 eingeleitet wird, konvektiv erwärmt wird. Anschließend wird das Substrat 10 durch die Schleusen 23b und 23c in die Kühlkammer 21' transportiert (Pfeil 24b) und dort mit Hilfe eines temperierten (in der Regel gekühlten) Gases, das über eine Gasführungseinrichtung 30' in die Kühlkammer 21' eingeleitet wird, konvektiv abgekühlt. Zwischen der Wärmebehandlungskammer 21 und der Kühlkammer 21' können weitere Prozessstufen 22 vorgesehen sein, was in Figur 1 durch gestrichelte Verbindungslinien angedeutet ist.

Zum Transport und zur Lagerung des Substrats 10 in der Wärmebehandlungskammer 21 und der Kühlkammer 21' dient eine Transporteinrichtung 25, die in Figur 1 als eine Schar horizontal ausgerichteter, drehbar gelagerter Transportrollen 26 angedeutet ist, auf denen das flächenhafte Substrat 10 aufliegt. Alternativ kann das Substrat 10 in beliebiger Winkellage, insbesondere auch senkrecht oder unter einem kleinen Winkel gegenüber der Vertikalrichtung geneigt, in den Behandlungskammern 20 angeordnet und transportiert werden.

Während der thermischen Bearbeitung des Substrats 10 herrscht in den thermischen Behandlungskammern 20 somit eine Gasatmosphäre, vorzugsweise näherungsweise bei Normaldruck. Das Gas kann Luft, aber auch ein Schutzgas oder ein Reaktivgas sein. Das Gas wird mit Hilfe der Gasführungseinrichtung 30, 30' über Düsenabschnitte 31, 31' auf das Substrat 10 geleitet, über eine Abführeinrichtung 33, 33' aus der thermischen Behandlungskammer 20 abgeführt, und über eine Rückführung 34, 34' wieder der Gasführungseinrichtung 30, 30' zugeführt. Wie aus den Detailansichten der Figuren 2a und 2b ersichtlich, umfasst die Abführrichtung 33 der Wärmebehandlungskammer 21 Abführhauben 35, die direkt oberhalb der Düsenabschnitte 31 der Gasführungseinrichtung 30 angeordnet sind, so dass das aus den Düsen 31 austretende Gas auf die Substratoberfläche 10 trifft, dort eine Erwärmung des Substrats 10 bewirkt und anschließend unmittelbar über die Abführhauben 35 abgesaugt wird (kleine Pfeile in Figuren 2a und 2b). Dadurch wird eine lokale Erwärmung des Substrats 10 erreicht, und es wird verhindert, dass das Gas an die Wände 27 der Behandlungskammer 20 gelangt. Die Düsenabschnitte 31 sind an rohrförmigen Gasverteilern 36, 36' angeordnet, von denen sie in Richtung des Substrats 10 abragen. An den dem Substrat 10 zugewandten Enden der Düsenabschnitte 31 befinden sich Auslassöffnungen 32, die in einer solchen Weise gestaltet sind, dass sie eine gezielte (fokussierte oder defokussierte) Gasbeaufschlagung der Substratoberfläche 10 gestatten. In dem in Figuren 2a und 2b gezeigten Ausführungsbeispiel verjüngen sich die Querschnitte 39 der Düsenabschnitte 31 zu den Auslassöffnungen 32 hin, so dass gerichteter Gasstrom erzeugt wird. Die Düsenabschnitte 31 sind in einer solchen Weise gestaltet, dass das zur Erwärmung bzw. Kühlung des Substrats 10 aus den Austrittsöffnungen 32 austretende Gas keine nennenswerte Druckbelastung des Substrats 10 hervorruft.

Die Gasverteiler 36 und/oder die Düsenabschnitte 31 können mit steuerbaren Ventilen 44 versehen sein, die einen gezielt erhöhten bzw. reduzierten Gasfluss in ausgewählten Gasverteilern bzw. Düsenabschnitten gestatten und es somit ermöglichen, die auf das Substrat 10 abgegebene Heizleistung lokal zu variieren. Dadurch kann ein sehr genau dosiertes, lokal variables Gasprofil erzeugt werden - und somit eine gezielte Beeinflussung der mittels des Gases im Substrat 10 erzeugten lokalen Erwärmung bzw. Kühlung erreicht werden. Auf diese Weise können temperaturbedingte Inhomogenitäten im Substrat 10 vermieden werden, was zu einer guten Temperaturgleichmäßigkeit führt.

Die Behandlungskammer 20 ist gasdicht gegenüber der Umgebung 2 verschließbar, so dass ihr Innenraum 8 während der Bearbeitung des Substrats 10 einen geschlossenen Raum bildet. Zur Evakuierung der Behandlungskammer 20 sind Vakuumpumpen 29, 29' vorgesehen. In jeder Behandlungskammer 21, 21' zirkuliert das jeweilige temperierte Gas in einem geschlossenen Gaskreislauf 40, 40', der durch die Gasführungseinrichtung 30, 30', den Innenraum 8, 8' jeweilige Behandlungskammer 21, 21', die Abführvorrichtung 33, 33' und die Rückführung 34, 34' gebildet wird. In der Gasführungseinrichtung 30, 30' ist eine Pumpe 37, 37' mit einem Motor 38, 38' angeordnet, der an eine Steuerungseinrichtung 50 angeschlossen ist und mit deren Hilfe ein steuer- oder regelbarer Gasfluss in der Gasführungseinrichtung 30, 30' erzeugt wird. Die Steuerungseinrichtung 50 dient auch zur Steuerung der lokalen Gasverteilung in der Gasführungseinrichtung mit Hilfe der Ventile 44.

Während aus Gründen der Übersichtlichkeit die Prinzipskizze der Figur 1 in den Behandlungskammern 20 Gasführungseinrichtungen 30, 30' zeigen, die ausschließlich oberhalb des Substrats 10 angeordnet sind und deswegen nur eine einseitige Gasbeaufschlagung des Substrats 10 gestatten, zeigt die Detaildarstellung der Wärmebehandlungskammer 21 (Figur 2a), dass die Gasführungseinrichtung 30 in der Regel sowohl ober- als auch unterhalb des Substrats 10 Auslassöffnungen 32 aufweist, so dass eine beidseitige konvektive Temperierung des Substrats 10 erfolgen kann. Zur Einstellung der Temperatur des Gases, das über die Gasführungseinrichtung 30, 30' auf das Substrat 10 geleitet wird, zeigt der in Figur 2a gezeigte Gaskreislauf 40 eine elektrisch betreibbare (Widerstands-)Heizvorrichtung 41, mit der das zirkulierende Gas auf eine gewünschte (beispielsweise mit Hilfe von Thermoelementen 46 in der Gasführungseinrichtung 30 messbare) Temperatur erhitzt wird. Die Leistung der Heizvorrichtung 41 wird mit Hilfe der Steuerungseinrichtung 50 geregelt. Alternativ (oder zusätzlich) zur Heizvorrichtung 41 kann zur Erhitzung des Gases in der Wärmebehandlungskammer 21 - ebenso wie zur Kühlung des Gases in der Kühlkammer 21'- ein Wärmetauscher 42 eingesetzt werden. Im Gaskreislauf 40 kann weiterhin eine Trocknungsvorrichtung 43 und/oder eine Filtervorrichtung zum Trocknen bzw. Reinigen des zirkulierenden Gases enthalten sein. Somit dient die Luft bzw. das (technische) Gas in der Behandlungskammer 20 als Wärmeträger; ein Teilstrom wird zur prozesstechnischen Behandlung des Gases aus dem Innenraum 8 der Bearbeitungskammer 20 herausgeführt, in der Gasführungseinrichtung 30 einer Veränderung (Erhitzung, Kühlung, Entfeuchtung, ...) unterzogen und danach wieder dem Innenraum 8 zugeführt wird. Ferner kann der Gaskreislauf mit einer Gasentsorgungsvorrichtung 45 verbunden sein, der Gas aus dem Gaskreislauf 40 bedarfsweise zugeführt werden kann.

Zusätzlich zur Konvektionsheizung des Substrats 10 mit Hilfe der Gasführungseinrichtung 30 kann eine Erhitzung des Substrats mit Hilfe von elektromagnetischer Strahlung, insbesondere von Infrarot-Strahlung, erfolgen. Hierzu können in der Wärmebehandlungskammer 21 Heizmittel 47 vorgesehen sein, die in Figur 2a als beheizbare Quarzstäbe dargestellt sind. Alternativ bzw. zusätzlich kann thermische Energie beispielsweise als (gepulste) elektromagnetische Strahlung über Fenster in die Wärmebehandlungskammer 21 eingebracht werden. Ist in der Wärmebehandlungskammer 21 ein solches Heizmittel 47 vorgesehen, so erfolgt der Wärmeübertrag auf das Substrat 10 sowohl mit Hilfe von Strahlung (aufgrund des Heizmittels 47) als auch durch Konvektion (aufgrund des Gases). Um die thermische Strahlung auf das Substrat zu konzentrieren bzw. eine Schädigung der Kammerwände 27 zu vermeiden, können im Innenraum 8 der Bearbeitungskammer 20 bzw. an den Kammerwänden 27 Reflektoren vorgesehen sein. Insbesondere können die Innenseiten der Wände 27 mit einem Werkstoff beschichtet sein, der ein hohes Reflektionsvermögen im Wellenlängenbereich der Heizmittel 47 hat und somit als Reflektor und als Hitzeschild wirkt.

Um die Wärmebehandlungskammer 21, die sich im Betrieb auf hoher Temperatur befinden kann, thermisch gegenüber der Umgebung 2 abzuschirmen, umfasst die Wärmebehandlungskammer 21 der Figuren 2a und 2b neben einer Innenkammer 3 - der eigentlichen Heizkammer - eine Außenkammer 4, die die Innenkammer 3 umgibt und als Thermoisolationsschild der Innenkammer 3 dient. Die Außenkammer 4 ist eine Vakuumkammer, die mit Hilfe einer Pumpe 5 evakuiert werden kann.

Zusätzlich bzw. alternativ kann die Wand 27 der Wärmebehandlungskammer 21 eine Temperierungseinrichtung aufweisen. Diese Temperierungseinrichtung kann insbesondere als ein in der Wand 27 verlaufendes (und in Figur 2a in einem Bereich der Wand 27 angedeutetes) Kanalsystem 7 von Kühl- bzw. Heizkanälen ausgebildet sein, mit der die Wand auf einer vorgegebenen Temperatur gehalten werden kann. Das Kanalsystem 7 schirmt somit den geheizten bzw. gekühlten Innenraum 8 der Behandlungskammer 20 thermisch gegenüber der Umgebung 2 bzw. der Außenkammer 4 ab und bildet ein Thermoisolationsschild des Innenraums 8 gegenüber der Umgebung. Das Kanalsystem 7 bildet Teil eines Kühl- oder Heizkreislauf für ein flüssiges Kühlmedium (beispielsweise ein Öl), das durch die Kanäle in der Kammerwand 7 zirkuliert.

Die Vorrichtung 1 ermöglicht ein sehr schnelles Aufheizen des Substrats 10 (bzw. ausgewählter Substratbereiche) mit einer Heizrate von > 20 Grad/sec. bis in einen Temperaturbereich von ca. 650°C in der Wärmebehandlungskammer 21 und ein sehr schnelles Abkühlen n des Substrats 10 in der von der Wärmebehandlungskammer 21 abgetrennten Kühlkammer 21', mit Kühlraten von > 20 Grad/sec. aus dem Temperaturbereich von ca. 650°C auf Raumtemperatur. Die Erhitzung sowie die Abkühlung können sowohl - wie in Figur 1 gezeigt - einseitig als auch - wie in Figuren 2a und 2b gezeigt - beidseitig des Substrats erfolgen.

Die Vorrichtung 1 bzw. die Behandlungskammer 20 eignet sich insbesondere zur Wärmebehandlung von Substraten im Zuge der Erzeugung transparenter leitfähiger Oxidschichten (TCOs), wie sie bei der Herstellung von Flachbildschirmen und Solarzellen verwendet werden. Weiterhin eignet sich die Vorrichtung 1 zum Einsatz bei der Herstellung von Dünnfilmsolarzellen bzw. Dünnfilmsolarmodulen mit einer Trägerschicht aus einem Glas bzw. Quarz, auf die eine Mo-Schicht als Elektrode und eine funktionelle Schicht aus einem Kupfer-Indium-Diselenid(CIS)-Halbleiter oder einem Kupfer-Indium-Gallium-Sulfo-Selenid(CIGSSe)-Halbleiter aufgetragen werden soll.

## Patentansprüche

1. Behandlungskammer (20, 21, 21') zur thermischen Bearbeitung eines flächigen Substrats (10)
mit einer Transporteinrichtung (25, 25') zur Beförderung und Lagerung des Substrats (10) während der thermischen Bearbeitung
und mit einer Gasführungseinrichtung (30, 30') zum konvektiven Erwärmen oder Kühlen des Substrats (10), wobel die Gasführungseinrichtung (30, 30') in einem dem Substrat (10) zugewandten Bereich Auslassöffnungen (32, 32') für das Gas aufweist, wobei die Behandlungskammer (20, 21, 21') eine Abführeinrichtung (33, 33') zur Abfuhr des über die Gasführungseinrichtung (30, 30') in die Behandlungskarmmer (20, 21, 21') eingeleiteten Gases aufweist und die Gasführungseinrichtung (30, 30') einen rohrförmigen Gasverteiler (36, 36') mit einer Vielzahl von auf das Substrat (10) ausgerichteten Düsenabschnitten (31, 31') umfasst, an deren Enden die Auslassöffnungen (32, 32') angeordnet sind,
dadurch gekennzelchnet, dass. dass die Abführeinrichtungen (33) als langgestreckte, entlang den Rohrabschnitten (36) angeordnete Abführhauben (35) ausgestaltet sind.

2. Behandlungskammer nach Anspruch 1, **dadurch gekennzeichnet, dass** der rohrförmige Gasverteiler (36) näherungswelse parallel zur Substratoberfläche (10) angeordnet ist,

3. Behandlungskammer (20, 21, 21') nach Anspruch 1 oder 2, **dadurch gekennzeichnet, dass** Transporteinrichtung (25) eine flächig aufliegende Anordnung der Substrate (10) erlaubt.

4. Behandlungskammer (20, 21, 21') nach Anspruch 3, **dadurch gekennzeichnet, dass** der rohrförmige Gasverteller (36, 36') und/oder die Düsenabschnitte (31, 31') steuerbare Ventile (44) zur Regelung des Gasflusses aufweist bzw. aufweisen.

5. Behandlungskammer (20, 21, 21') nach Anspruch 3 oder 4, **dadurch gekennzeichnet, dass** die Querschnitte (39) der Düsenabschnitte (31, 31') sich in Richtung zu den Auslassöffnungen (32, 32') hin verjüngen.

6. Behandlungskammer (20, 21) nach einem der Ansprüche 3 bis 5, **dadurch gekennzeichnet,**
**dass** die Düsenabschnitte (31) näherungsweise senkrecht von den Rohrabschnitten (36) in Richtung der Substratoberfläche (10) abragen..

7. Behandlungskammer (20, 21, 21') nach einem der vorangehenden Ansprüche, **dadurch gekennzeichnet, dass** die Behandlungskammer (20, 21, 21') während der thermischen Bearbeitung des Substrats (10) einen geschlossenen Raum bildet.

8. Behandlungskammer (20, 21, 21') nach Anspruch 7, **dadurch gekennzeichnet, dass** die Gasführungseinrichtung (30, 30') Teil eines geschlossenen Gasführungskreislaufs (40, 40') bildet.

9. Behandlungskammer (20, 21, 21') nach einem der vorangehenden Ansprüche, **dadurch gekennzeichnet, dass** die Gasführungseinrichtung (30, 30') einen Wärmetauscher (42) zur Heizung oder Kühlung des der Substratoberfläche (10) zugeleiteten Gases enthält.

10. Behandlungskammer (20, 21, 21') nach einem der vorangehenden Ansprüche, **dadurch gekennzeichnet, dass** die Gasführungseinrichtung (30, 30') zumindest eine Pumpe (37, 37') enthält.

11. Behandlungskammer (20, 21, 21') nach einem der vorangehenden Ansprüche, **dadurch gekennzeichnet, dass** die Gasführungseinrichtung (30, 30') eine Trocknungsvorrichtung (43) und/oder eine Filtervorrichtung zur Trocknung bzw. Reinigung des der Substratoberfläche (10) zugeleiteten Gases enthält.

12. Behandlungskammer (20, 21, 21') nach einem der vorangehenden Ansprüche, **dadurch gekennzeichnet, dass** die Gasführungseinrichtung (30, 30') eine Steuereinrichtung (50) zur Leistungsregelung der Pumpe (37) und/oder zur Durchflussregelung in den rohrförmigen Gasverteilern (36, 36') und/oder in den Düsenabschnitten (31, 31') umfasst.

13. Behandlungskammer (20, 21, 21') nach einem der vorangehenden Ansprüche, **dadurch gekennzeichnet, dass** die Behandlungskammer (20, 21, 22) verschließbare Öffnungen (23a - 23d) zum Ein- und Ausführen des Substrats (10) umfasst.

14. Behandlungskammer (20, 21, 21'), insbesondere nach einem der vorangehenden Ansprüche, **dadurch gekennzeichnet, dass** die Behandlungskammer (20, 21, 21') einen Thermoisolationsschild (4) aufweist.

15. Behandlungskammer (20, 21, 21') nach Anspruch 14, **dadurch gekennzeichnet, dass** der Thermoisolationsschild als gasdicht verschließbare Außenkammer (4) ausgebildet ist, die eine gasdicht verschließbare Innenkammer (3) umgibt.

16. Behandlungskammer (20, 21, 21') nach Anspruch 15, **dadurch gekennzeichnet, dass** der Thermoisolationsschild durch eine im Bereich der Wand (27) der Behandlungskammer (20, 21) angeordnete Temperierungseinrichtung gebildet ist.

17. Behandlungskammer (20, 21, 21') nach Anspruch 16, **dadurch gekennzeichnet, dass** die Temperierungseinrichtung durch ein System (7) von Kühl- bzw. Heizkanälen gebildet ist.

18. Behandlungskammer (20, 21, 21') nach Anspruch 16 oder 17, **dadurch gekennzeichnet, dass** die Temperierungseinrichtung Teil eines Heiz- bzw. Kühlkreislaufs bildet, in dem ein flüssiges Temperierungsmedium zirkuliert.

19. Behandlungskammer (20, 21') nach einem der vorangehenden Ansprüche, **dadurch gekennzeichnet, dass** die Behandlungskammer eine Kühlkammer (21') ist.

20. Behandlungskammer (20, 21) nach einem der vorangehenden Ansprüche, **dadurch gekennzeichnet, dass** die Behandlungskammer eine Wärmebehandlungskammer (21) ist.

21. Behandlungskammer (20, 21) nach Anspruch 20, **dadurch gekennzeichnet, dass** die Gasführungseinrichtung (30) eine elektrisch betreibbare Heizvorrichtung (41) zur Heizung des Gases enthält.

22. Behandlungskammer (20, 21) nach Anspruch 20 oder 21, **dadurch gekennzeichnet, dass** im Innenraum (8) der Behandlungskammer (20, 21) ein Heizmittel (47) zur Abgabe thermischer Energie angeordnet ist.

23. Behandlungskammer (20, 21, 21') nach einem der vorangehenden Ansprüche, **dadurch gekennzeichnet, dass** die Innenwände der Behandlungskammer (21) zumindest abschnittsweise aus einem reflektierenden Werkstoff (9) bestehen.

24. Kammer (1) zur thermischen Bearbeitung eines Substrats (10) mit einer Wärmebehandlungskammer (21) und/oder einer Kühlkammer (21') nach einem der Ansprüche 1 bis 23.

25. Verfahren zur thermischen Bearbeitung eines flächigen Substrats (10) in einer Behandlungskammer (20, 21, 21 '), wobei
mittels einer Transporteinrichtung (25, 25') eine Beförderung und Lagerung des Substrats (10) während der thermischen Bearbeitung erfolgt,
und mittels einer Gasführungseinrichtung (30, 30') ein konvektives Erwärmen oder Kühlen des Substrats (10) erfolgt, wobei die Gasführungseinrichtung (30, 30') in einem dem Substrat (10) zugewandten Bereich Auslassöffnungen (32, 32') für das Gas aufweist, und die Gasführungseinrichtung (30, 30') einen rohrförmigen Gasverteiler (36, 36') mit einer Vielzahl von auf das Substrat (10) ausgerichteten Düsenabschnitten (31, 31') umfasst, an deren Enden die Auslassöffnungen (32, 32') angeordnet sind, wobei mittels einer Abführeinrichtung (33, 33') eine Abfuhr des über die Gasführungseinrichtung (30, 30') in die Behandlungskammer (20, 21, 21') eingeleiteten Gases erfolgt, **dadurch gekennzeichnet, dass** die Abfuhr mittels Abführeinrichtungen (33) erfolgt, die als langgestreckte, entlang den Rohrabschnitten (36) angeordnete Abführhauben (35) ausgestaltet sind

## Claims

1. Treatment chamber (20, 21, 21') for thermal processing of an areal substrate (10)
with a transport arrangement (25, 25') for conveying and supporting the substrate (10) during the thermal processing
and with a gas-guiding arrangement (30, 30') for convective heating or cooling of the substrate (10), the gas-guiding arrangement (3C, 3D') having outlet openings (32, 32') for the gas in a region facing the substrate (10),
the treatment chamber (20, 21, 21') having a removal arrangement (33, 33') for the removal of the gas introduced into the treatment chamber (20, 21, 21') via the gas-guiding arrangement (30, 30'), and
the gas-guiding arrangement (30, 30') comprising a tubular gas distributor (36, 36') with a multiplicity of nozzle sections (31, 31') directed at the substrate (10), with the outlet openings (32, 32') being arranged at the ends of said nozzle sections,
**characterized in that** the removal arrangements (33) are embodied as elongate removal domes (35) arranged along the tube sections (36).

2. Treatment chamber according to Claim 1, **characterized in that** the tubular gas distributor (36) is arranged approximately parallel to the substrate surface (10).

3. Treatment chamber (20, 21, 21') according to Claim 1 or 2, **characterized in that** the transport arrangement (25) permits an areal arrangement of the substrates (10).

4. Treatment chamber (20, 21, 21') according to Claim 3, **characterized in that** the tubular gas distributor (36, 36') and/or the nozzle sections (31, 31') has or have controllable valves (44) for regulating the gas flow.

5. Treatment chamber (20, 21, 21') according to Claim 3 or 4, **characterized in that** the nozzle section (31, 31') cross sections (39) taper in the direction towards the outlet openings (32, 32').

6. Treatment chamber (20, 21) according to one of Claims 3 to 5, **characterized in that** the nozzle sections (31) protrude approximately perpendicularly from the tube sections (36) in the direction of the substrate surface (10).

7. Treatment chamber (20, 21, 21') according to one of the preceding claims, **characterized in that** the treatment chamber (20, 21, 21') forms an enclosed space during the thermal processing of the substate (10).

8. Treatment chamber (20, 21, 21') according to Claim 7, **characterized in that** the gas-guiding arrangement (30, 30') forms part of a closed gas-guiding circuit (40, 40').

9. Treatment chamber (20, 21, 21') according to one of the preceding claims, **characterized in that** the gas-guiding arrangement (30, 30') contains a heat exchanger (42) for heating or cooling the gas supplied to the substrate surface (10).

10. Treatment chamber (20, 21, 21') according to one of the preceding claims, **characterized in that** the gas-guiding arrangement (30, 30') contains at least one pump (37, 37').

11. Treatment chamber (20, 21, 21') according to one of the preceding claims, **characterized in that** the gas-guiding arrangement (30, 30') contains a drying device (43) and/or a filter device for drying or cleaning the gas supplied to the substrate surface (10).

12. Treatment chamber (20, 21, 21') according to one of the preceding claims, **characterized in that** the gas-guiding arrangement (30, 30') comprises a control arrangement (5C) for regulating the power of the pump (37) and/or for regulating the flow through the tubular gas distributors (36, 36') and/or through the nozzle sections (31, 31').

13. Treatment chamber (20, 21, 21') according to one of the preceding claims, **characterized in that** the treatment chamber (20, 21, 22) comprises sealable openings (23a-23d) for supplying and removing the substrate (10).

14. Treatment chamber (23, 21, 21'), more particularly according to one of the preceding claims, **characterized in that** the treatment chamber (20, 21, 21') has a thermoinsulation shield (4).

15. Treatment chamber (20, 21, 21') according to Claim 14, **characterized in that** the thermoinsulation shield is designed as an outer chamber (4) that can be sealed in a gas-tight fashion and surrounds an innner chamber (3) that can be sealed in a gas-tight fashion.

16. Treatment chamber (20, 21, 21') according to Claim 15, **characterized in that** the thermoinsulation shield is formed by a temperature-control arrangement arranged in the region cf the wall (27) of the treatment chamber (20, 21).

17. Treatment chamber (20, 21, 21') according to Claim 16, **characterized in that** the temperature-control arrangement is formed by a system (7) of cooling or heating channels.

18. Treatment chamber (20, 21, 21') according to Claim 16 or 17, **characterized in that** the temperature-control arrangement forms part of a heating or cooling circuit in which a liquid temperature-control medium circulates.

19. Treatment chamber (20, 21') according to one of the preceding claims, **characterized in that** the treatment chamber is a cooling chamber (21').

20. Treatment chamber (20, 21) according to one of the preceding claims, **characterized in that** the treatment chamber is a heat-treatment chamber (21).

21. Treatment chamber (20, 21) according to Claim 20, **characterized in that** the gas-guiding arrangement (30) contains an electrically operable heating device (41) for heating the gas.

22. Treatment chamber (20, 21) according to Claim 20 or 21, **characterized in that** a heating means (47) for emitting thermal energy is arranged in the inferior (8) of the treatment chamber (20, 21).

23. Treatment chamber (20, 21, 21') according to one of the preceding claims, **characterized in that** the inner walls of the treatment chamber (21) at least in sections consist of a reflecting material (9).

24. Chamber (1) for thermal processing of a substrate (10) with a heat-treatment chamber (21) and/or a cooling chamber (21') according to one of Claims 1 to 23.

25. Method for thermal processing of an areal substrate (10) in a treatment chamber (20, 21, 21'), in which
a transport arrangement (25, 25') conveys and supports the substrate (10) during the thermal processing,
and there is convective heating or cooling of the substrate (10) by means of a gas-guiding arrangement (30, 3C'), the gas-guiding arrangement (30, 30') having outlet openings (32, 32') for the gas in a region facing the substrate (10), and the gas-guiding arrangement (30, 30') comprises a tubular gas distributor (36, 36') with a multiplicity of nozzle sections (31, 31') directed at the substrate (10), with the outlet openings (32, 32') being arranged at the ends of said nozzle sections a removal arrangement (33, 33') removing the gas introduced into the treatment chamber (20, 21, 21') via the gas-guiding arrangement (30, 30'), **characterized in that** the removal is carried out by means of removal arrangements (33) which are embodied as elongate removal domes (35) arranged along the tube sections (36).

## Revendications

1. Chambre de traitement (20, 21, 21') pour le traitement thermique d'un substrat plat (10),
avec un système de manutention (25, 25') pour le transport et le stockage du substrat (10) pendant le traitement thermique,
et avec un système de guidage de gaz (30, 30') pour le chauffage ou le refroidissement par convection du substrat (10), dans laquelle le système de guidage de gaz (30, 30') présente, dans une région tournée vers le substrat (10), des orifices de sortie (32, 32') pour le gaz, dans laquelle la chambre de traitement (20, 21, 21') présente un système d'évacuation (33, 33') pour l'évacuation du gaz introduit dans la chambre de traitement (20, 21, 21') par le système de guidage de gaz (30, 30') et le système de guidage de gaz (30, 30') comprend un distributeur de gaz tubulaire (36, 36') avec une multiplicité de parties de buses (31, 31') orientées vers le substrat (10), aux extrémités desquelles les orifices de sortie (32, 32') sont disposés,
**caractérisée en ce que** les systèmes d'évacuation (33) sont réalisés sous la forme de hottes d'évacuation allongées (35) disposées le long des parties de tubes (36).

2. Chambre de traitement selon la revendication 1, **caractérisée en ce que** le distributeur de gaz tubulaire (36) est disposé approximativement parallèlement à la surface du substrat (10).

3. Chambre de traitement (20, 21, 21') selon la revendication 1 ou 2, **caractérisée en ce que** le système de manutention (25) permet un agencement reposant à plat du substrat (10).

4. Chambre de traitement (20, 21, 21') selon la revendication 3, **caractérisée en ce que** le distributeur de gaz tubulaire (36, 36') et/ou les parties de buses (31, 31') présente/présentent des soupapes (44) réglables pour la régulation du flux de gaz.

5. Chambre de traitement (20, 21, 21') selon la revendication 3 ou 4, **caractérisée en ce que** les sections transversales (39) des parties de buses (31, 31') se rétrécissent en direction des orifices de sortie (32, 32').

6. Chambre de traitement (20, 21) selon l'une quelconque des revendications 3 à 5, **caractérisée en ce que** les parties de buses (31) sortent approximativement perpendiculairement sur les parties de tubes (36) en direction de la surface du substrat (10).

7. Chambre de traitement (20, 21, 21') selon l'une quelconque des revendications précédentes, **caractérisée en ce que** la chambre de traitement (20, 21, 21') forme un espace fermé pendant le traitement thermique du substrat (10).

8. Chambre de traitement (20, 21, 21') selon la revendication 7, **caractérisée en ce que** le système de guidage de gaz (30, 30') fait partie d'un circuit fermé de guidage de gaz (40, 40').

9. Chambre de traitement (20, 21, 21') selon l'une quelconque des revendications précédentes, **caractérisée en ce que** le système de guidage de gaz (30, 30') comprend un échangeur de chaleur (42) pour le chauffage ou le refroidissement du gaz envoyé à la surface du substrat (10).

10. Chambre de traitement (20, 21, 21') selon l'une quelconque des revendications précédentes, **caractérisée en ce que** le système de guidage de gaz (30, 30') comprend au moins une pompe (37, 37').

11. Chambre de traitement (20, 22, 21') selon l'une quelconque des revendications précédentes, **caractérisée en ce que** le système de guidage de gaz (30, 30') comprend un dispositif de séchage (43) et/ou un dispositif de filtrage pour le séchage ou l'épuration du gaz envoyé à la surface du substrat (10).

12. Chambre de traitement (20, 21, 21') selon l'une quelconque des revendications précédentes, **caractérisée en ce que** le système de guidage de gaz (30, 30') comprend un système de commande (50) pour la régulation de la puissance de la pompe (37) et/ou pour la régulation du débit dans les distributeurs de gaz tubulaires (36, 36') et/ou dans les parties de buses (31, 31').

13. Chambre de traitement (20, 21, 21') selon l'une quelconque des revendications précédentes, **caractérisée en ce que** la chambre de traitement (20, 21, 21') comprend des ouvertures pouvant être fermées (23a - 23d) pour l'entrée et la sortie du substrat (10).

14. Chambre de traitement (20, 21, 21'), en particulier selon l'une quelconque des revendications précédentes, **caractérisée en ce que** la chambre de traitement (20, 21, 21') présente un blindage d'isolation thermique (4).

15. Chambre de traitement (20, 21, 21') selon la revendication 14, **caractérisée en ce que** le blindage d'isolation thermique est constitue par une chambre extérieure (4) pouvant être fermée de façon étanche au gaz, qui entoure une chambre intérieure (3) pouvant être fermée de façon étanche au gaz.

16. Chambre de traitement (20, 21, 21') selon la revendication 15, **caractérisée en ce que** le blindage d'isolation thermique est formé par un système d'égalisation de la température disposé dans la région de la paroi (27) de la chambre de traitement (20, 21).

17. Chambre de traitement (2C, 21, 21') selon la revendication 16, **caractérisée en ce que** le système d'égalisation de la température est formé par un système (7) de canaux de refroidissement ou de chauffage.

18. Chambre de traitement (2C, 21, 21') selon la revendication 16 ou 17, **caractérisée en ce que** le système d'égalisation de la température fait partie d'un circuit de chauffage ou de refroidissement, dans lequel circule un agent liquide d'égalisation de la température.

19. Chambre de traitement (20, 21') selon l'une quelconque des revendications précédentes, **caractérisée en ce que** la chambre de traitement est une chambre de refroidissement (21').

20. Chambre de traitement (20, 21) selon l'une quelconque des revendications précédentes, **caractérisée en ce que** la chambre de traitement est une chambre de traitement thermique (21).

21. Chambre de traitement (20, 21) selon la revendication 20, **caractérisée en ce que** le système de guidage de gaz (30) comporte un dispositif de chauffage (41) pouvant fonctionner à l'électricité pour le chauffage du gaz.

22. Chambre de traitement (20, 21) selon la revendication 20 ou 21, **caractérisée en ce qu'**un moyen de chauffage (47) destiné à fournir de l'énergie thermique est disposé dans l'espace intérieur (8) de la chambre de traitement (20, 21).

23. Chambre de traitement (20, 21, 21') selon l'une quelconque des revendications précédentes, **caractérisée en ce que** les parois intérieures de la chambre de traitement (21) se composent au moins localement d'un matériau réfléchissant (9).

24. Chambre (1) pour le traitement thermique d'un substrat (10) avec une chambre de traitement thermique (21) et/ou une chambre de refroidissement (21') selon l'une quelconque des revendications 1 à 23.

25. Procédé de traitement thermique d'un substrat plat (10) dans une chambre de traitement thermique (20, 21, 21'), dans lequel
on effectue un transport et un stockage du substrat (10) au moyen d'un système de manutention (25, 25') pendant le traitement thermique,
et on opère un chauffage ou un refroidissement du substrat (10) par convection au moyen d'un système de guidage de gaz (30, 30'), dans lequel le système de guidage de gaz (30, 30') présente, dans une région tournée vers le substrat (10), des orifices de sortie (32, 32') pour le gaz, et le système de guidage de gaz (30, 30') comprend un distributeur de gaz tubulaire (36, 36') avec une multiplicité de parties de buses (31, 31') orientées vers le substrat (10), aux extrémités desquelles les orifices de sortie (32, 32') sont disposés, dans lequel on effectue, au moyen d'un système d'évacuation (33, 33'), une évacuation du gaz introduit dans la chambre de traitement (20, 21, 21') par le système de guidage de gaz (30, 30'), **caractérisé en ce que** l'on effectue l'évacuation au moyen de systèmes d'évacuation (33), gui sont réalisés sous la forme de hottes d'évacuation allongées (35) disposées le long des parties de tubes (36).
